# EUROPEAN PATENT SPECIFICATION

(11) **EP 4 548 139 B1**
(45) Date of publication and mention of the grant of the patent: **24.06.2026**
(21) Application number: 23729800.5
(22) Date of filing: 31.05.2023
(51) Int. Cl.: G02B 6/42

(54) **BONDING STRUCTURE, PHOTONIC INTEGRATED CIRCUIT, AND METHOD FOR ACTIVE ALIGNMENT OF OPTICAL AXIS OF SEMICONDUCTOR OPTICAL DEVICE WITH OPTICAL AXIS OF OPTICAL CIRCUIT ON SUBSTRATE**
VERBINDUNGSSTRUKTUR, PHOTONISCHE INTEGRIERTE SCHALTUNG UND VERFAHREN ZUR AKTIVEN AUSRICHTUNG DER OPTISCHEN ACHSE EINER OPTISCHEN HALBLEITERVORRICHTUNG AUF EINEM SUBSTRAT
STRUCTURE DE LIAISON, CIRCUIT INTÉGRÉ PHOTONIQUE ET PROCÉDÉ D'ALIGNEMENT ACTIF D'AXE OPTIQUE DE DISPOSITIF OPTIQUE À SEMI-CONDUCTEUR AVEC AXE OPTIQUE DE CIRCUIT OPTIQUE SUR SUBSTRAT

(30) Priority: 29.06.2022 FI 20225594
(43) Date of publication of application: 07.05.2025
(73) Proprietor: Teknologian tutkimuskeskus VTT Oy, 02150 Espoo (FI)
(72) Inventor: LEE, Jae-Wung, 02150 Espoo (FI); HARJANNE, Mikko, 02150 Espoo (FI); HASSINEN, Tomi, 02150 Espoo (FI); AALTO, Timo, 02150 Espoo (FI); DELROSSO, Giovanni, 02150 Espoo (FI)
(74) Representative: Berggren Oy
(86) International application number: PCT/FI2023/050304
(87) International publication number: WO 2024/003442

(56) References cited:
- EP-A2- 1 424 748
- US-A- 5 700 987
- US-A1- 2002 106 831
- US-A1- 2003 228 084
- US-A1- 2015 348 926
- US-B1- 10 998 297

## Description

### FIELD OF THE INVENTION

The present invention relates in general to photonics devices and more specifically to bonding structures for bonding a semiconductor optical device onto a substrate. In particular, however not exclusively, the present invention concerns a bonding structure for active alignment of an optical axis of a semiconductor optical device with an optical axis of an optical circuit on the substrate.

### BACKGROUND

In known photonics devices, the optical circuit is design and adapted so that when a semiconductor optical device is placed, such as bonded, to the substrate having the optical circuit, the optical axes thereof are meant to be aligned with each other. In the ideal case, the alignment of the axes would be proper as designed. However, in practice, this is always not the case.

There may be, for example, differences between the real spot and the expected spot where laser is coming out of the semiconductor optical device which then causes misalignment with the optical axis of the optical circuit. On the other hand, there can be bonding errors, for example, due to particles, squeezing of bonding material, or slip, etc. Furthermore, defects on facet, for example, because of tilting due to a process issue or the effect of the thickness of an anti-reflective coating. Still further, there may be other process or design errors, such as during or in the fabrication or bonding. Thus, there are many factors which can cause misalignment of the optical axes in practical application, even if the device would be carefully designed so that the alignment should be correct after the bonding of components onto the substrate.

Publication US 5 700 987 A discloses a method and device for aligning and soldering a first optical device, such as a laser, to a substrate with improved alignment stability. A plurality of solder elements are positioned between the device and the substrate, each associated with a resistive heater element. The solder elements are sequentially reflowed in groups, a first group is reflowed and cooled to tack the device in position, followed by subsequent groups to complete bonding. This stepwise reflow minimizes thermal stresses, energy consumption, and misalignment. The document also teaches the use of thermal barriers, e.g. silicon dioxide, to localize heating and improve bonding precision between optical components such as a laser and an optical fiber.

### SUMMARY

The invention provides a bonding structure as defined in independent claim 1, and a method of active alignment using the bonding structure as defined in independent claim 11. Further embodiments are set out in the dependent claims.

The present invention provides a bonding structure, a photonic integrated circuit, and a method for active alignment of an optical axis of a semiconductor optical device with an optical axis of an optical circuit on a substrate. The present invention provides advantages over known solutions in that a reliable bonding of components with good optical alignment is achieved. The optical alignment can be actively controlled by the use of the bonding structure so as to obtain proper alignment between the optical axes. Various other advantages will become clear to a skilled person based on the following detailed description.

The expression "a plurality of" may refer to any positive integer starting from two (2), that is, being at least two, two, at least three, three, etc.

The terms "first", "second" and "third" are herein used to distinguish one element from other element, and not to specially prioritize or order them, if not otherwise explicitly stated.

The exemplary embodiments of the present invention presented herein are not to be interpreted to pose limitations to the applicability of the appended claims. The verb "to comprise" is used herein as an open limitation that does not exclude the existence of also unrecited features. The features recited in dependent claims are mutually freely combinable unless otherwise explicitly stated.

The novel features which are considered as characteristic of the present invention are set forth in particular in the appended claims. The present invention itself, however, both as to its construction and its method of operation, together with additional objectives and advantages thereof, will be best understood from the following description of specific embodiments when read in connection with the accompanying drawings.

### BRIEF DESCRIPTION OF FIGURES

Some embodiments of the invention are illustrated by way of example, and not by way of limitation, in the figures of the accompanying drawings.
Figure 1 illustrates schematically a bonding structure.
Figures 2A-2D illustrate schematically some stages of aligning and bonding a semiconductor optical device with an optical circuit on a substrate using a bonding structure.
Figures 3A and 3B illustrate schematically examples of the alignment of an optical axis of a semiconductor optical device with that of an optical circuit on a substrate.
Figure 4 illustrates schematically a bonding structure.
Figures 5A-5C illustrate schematically some stages of aligning and bonding a semiconductor optical device with an optical circuit on a substrate using a bonding structure.
Figure 6 illustrate schematically a flip-chip bonding device or arm utilizable in aligning an optical axis of a semiconductor optical device with that of an optical circuit on a substrate.
Figure 7 illustrates schematically a photonic integrated circuit as viewed from above.
Figure 8 shows a flow diagram of a method.

### DETAILED DESCRIPTION OF SOME EMBODIMENTS

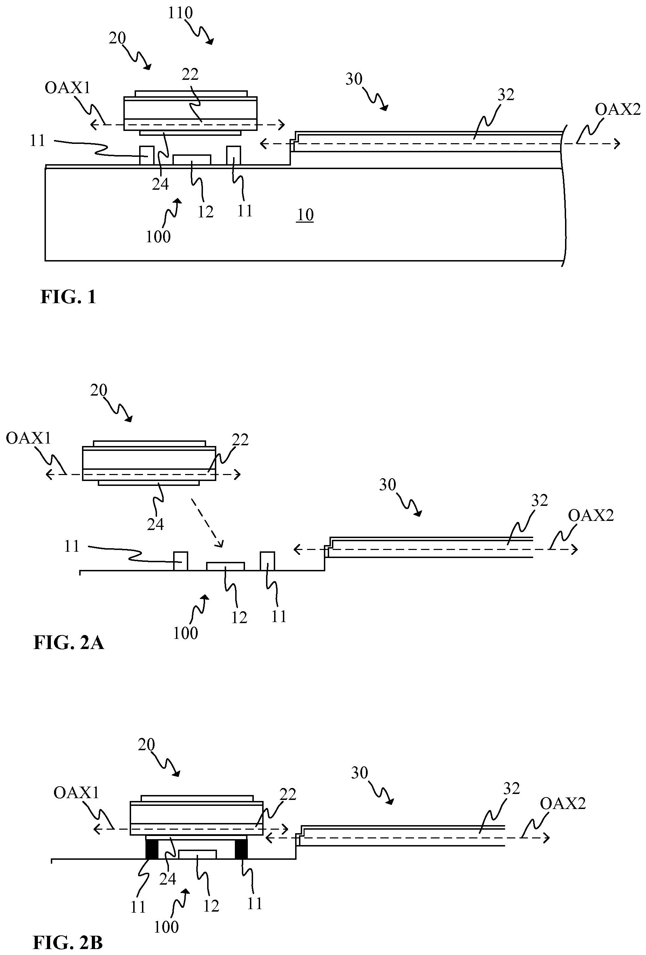

Figure 1 illustrates schematically a bonding structure 100. Also, a semiconductor optical device 20 and a portion of an optical circuit 30 on a substrate 10, such as silicon photonics platform, are illustrated. The bonding structure 100 in Fig. 1 comprises at least one first bonding member 11 on the substrate 10 for first, or initial, bonding the semiconductor optical device 20 to the substrate 10, wherein the first bonding member 11 is made of material exhibiting plastic deformation to allow deforming of the at least one first bonding member 11 during the active alignment. Furthermore, the bonding structure 100 comprises at least one second bonding member 12 on the substrate 10 for second, or final, bonding the semiconductor optical device 20 to the substrate 10 upon completion or after the active alignment. Preferably, the at least one second bonding member 12 may be arranged adjacent to the first bonding member(s) 11 on the substrate 10.

Furthermore, an opposite end of the at least one first bonding member 11 relative to the substrate 10, preferably, extends beyond an opposite end of the at least one second bonding member 12 relative to the substrate 10. Thus, the semiconductor optical device 20 becomes first in contact with the at least one first bonding member 11 when the device 20 is arranged towards the substrate 10 to be bonded before becoming in contact with the second bonding member(s) 12.

The second bonding member(s) 12 is arranged to act as a stopper during or upon completion of the active alignment. Thus, the movement of the semiconductor optical device 20 may be limited to certain position by the second bonding member(s) 12. The certain position is, preferably, a position in which the alignment is sufficiently good, if not optimal.

As can be seen, the semiconductor optical device 20 defines an optical axis OAX1, that is a first optical axis, which is the direction into which the optical signal, such as light or laser, exits the device 20. On the other hand, the optical circuit 30 also defines an optical axis OAX2, that is a second optical axis, which is related to the positioning/orientation of the waveguide of the optical circuit 30. To properly function, the optical axis OAX1 of the semiconductor optical device 20 and the optical axis OAX2 of the optical circuit 30 must be so positioned, or aligned, with respect to each other so that the optical signal provided by the semiconductor optical device 20 can enter the optical circuit 30 efficiently enough to be transmitted further on. Thus, the alignment of the axes OAX1, OAX2 relates most importantly to the alignment of the exit point and entry point of the optical signal from the semiconductor optical device 20 and to the optical circuit 30, respectively.

Regarding the semiconductor optical device 20, which may be a semiconductor optical amplifier, a photodiode, or a laser diode, it may comprise an active layer 22 from which the optical signal is being outputted. The semiconductor optical device 20 may also comprise a first contact layer 24, or a bottom contact layer or electrode, by which the device 20 is to be connected, such as bonded, to the substrate 10. As known to a person skilled in the art, the semiconductor optical device 20 may also comprise other layers, such as a second contact layer (such as a top contact layer or electrode on the top of the device 20 of Fig. 1), as well as antireflective layer(s) and cladding layers.

Regarding the optical circuit 30, it may comprise a waveguide 32, such as a silicon waveguide, for transmitting optical signal therein. As shown in Fig. 1, the optical circuit 30 may be part of a photonic integrated circuit 110, such as of a silicon photonic device.

In Fig. 1, there are shown two first bonding members 11, however, there may be only one or more than two, such as four. The first bonding member(s) 11 may, preferably, be made of electrically conductive material, such as of electrically conductive metal. Although not shown in Fig. 1, the first bonding member(s) 11 may be provided onto a specific contact pad(s) or area(s) provided on or define by the substrate 10. The contact pad(s) or area(s) may then be further connected to other components or circuit of the device.

In addition, there may be only one second bonding member 12 or several of them. The second bonding member 12 may also be provided onto a specific contact pad(s) or area(s) provided on or define by the substrate 10. The contact pad(s) or area(s) may be the same or different than the ones utilized for the first bonding member(s) 11.

In various embodiments, the material of the first bonding member(s) 11 is substantially or at least comprises mostly of the same material than the first contact layer 24 of the semiconductor optical device 20.

Figures 2A-2D illustrate schematically some stages of aligning and bonding a semiconductor optical device 20 with an optical circuit 30 on a substrate 10 using a bonding structure 100. As visible in Figs. 2A-2D, said components/elements may be substantially similar to the ones illustrated in and described in connection to Fig. 1.

Figure 2A illustrates the semiconductor optical device 20 between brought into the vicinity of the substrate 10 and towards the bonding structure 100 thereon.

Figure 2B illustrates the semiconductor optical device 20 being first, or initially, bonded to the first bonding members 11, for example, by using an elevated temperature to at least partially melt the first bonding members 11 and/or the first contact layer 24, thereby bonding them to each other. Other bonding techniques may alternatively be used. In Fig. 2B, the first bonding members 11 are shown with black fill color to indicate that they are bonded to the device 20.

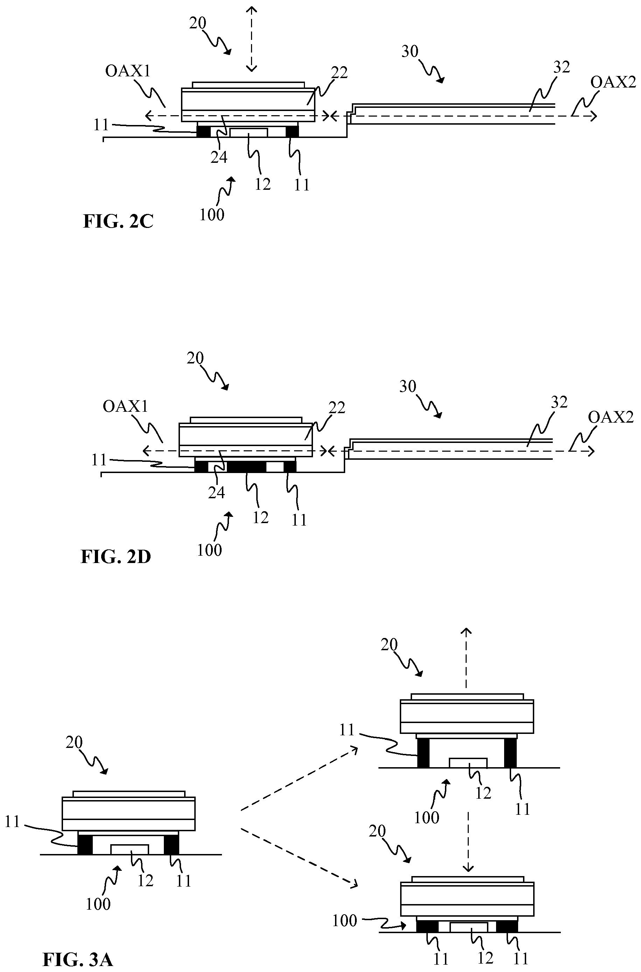

Figure 2C illustrates the semiconductor optical device 20 being moved in the vertical direction to align the optical axes OAX1, OAX2. During the alignment, in this movement in the vertical direction, the first bonding members 11, which are made of material exhibiting plastic deformation, deform due to the force utilized to move the semiconductor optical device 20. Once a sufficiently good alignment has been obtained, the alignment is completed. This may entail having the axes OAX1, OAX2 at a distance from each other which is less than a distance threshold or the optical signal may be measured to be sufficiently coupled to the optical circuit 30 so that, for example, the silicon photonic device can function properly.

Figure 2D illustrates the semiconductor optical device 20 being second, or finally, bonded to the substrate 10 by the at least one second bonding member 12. In this case too, the second bonding member 12 is shown with black fill color to indicate that the bonding has been performed. The bonding by the second bonding member(s) 12, such as by solder or eutectic bonding material, is, preferably, designed to provide even better bonding to the substrate 10 than the first bonding so that the semiconductor optical device 20 is not easily movable later on. The second bonding member 12 is thus, preferably, not exhibiting plastic deformation but material/composition which provide more rigid bonding is utilized, such as utilizing typical solder or eutectic bonding materials. For example, tin or tin lead type materials may be utilized for the second bonding member 12. In a way, the second bonding then fixes the semiconductor optical device 20 to its aligned position.

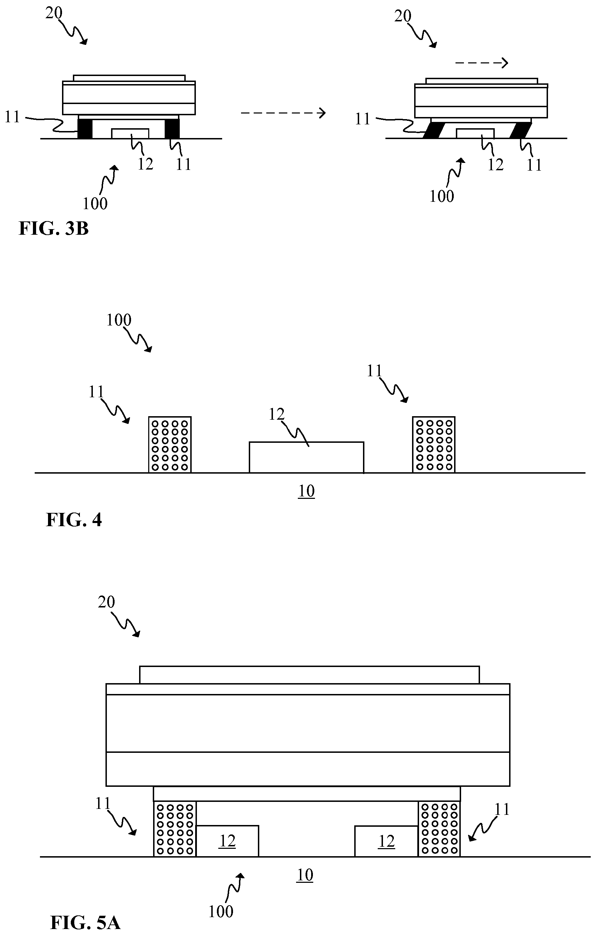

Figures 3A and 3B illustrate schematically examples of the alignment of an optical axis OAX1 of a semiconductor optical device 20 with that of an optical circuit 30 on a substrate 10. In Fig. 3A, the semiconductor optical device 20 is being moved in a vertical direction, up and/or down. In Fig. 3A, it is shown, or in fact exaggerated, that the width of the first bonding members 11 may alter during the movement. For example, when stretching the first bonding members 11 to be longer, the width of them may reduce such as shown on right in the top portion of the figure. On the hand, when compressing the first bonding members 11 against the substrate 10 to be shorter, the width of the first bonding members 11 may increase.

In Fig. 3B, the semiconductor optical device 20 is being moved in a horizontal direction, left and/or right. As both ends of the first bonding members 11 are bonded to their corresponding counterparts, the horizontal movement produces inclined or tilted first bonding members 11. The tilting may be utilized to increase or, preferably, decrease a gap between the semiconductor optical device 20 and the optical circuit 30. Alternatively or in addition, the tilting can be utilized to simultaneously move the semiconductor optical device 20 in both the vertical and the horizontal directions, resulting in rotative movement around the coupling point of the first bonding members 11 to the substrate 10. In this case, the width of the first bonding members 11 can be maintained, however, it can also be altered.

Figure 4 illustrates schematically a bonding structure 100. In the bonding structure 100 of Fig. 4, the material of the first bonding member 11 is porous metal. This is indicated by the small circles within the bonding members 11 which imply porosity of the material. In various embodiments, the porous metal is porous copper, porous aluminum, or porous gold. In this case, the porosity of the first bonding member(s) 11 provides the property of plastic deformation to the first bonding member(s) 11.

In various embodiments, the material of the first contact layer 24 of the semiconductor optical device 20 may be the same as the material of the porous metal of the first bonding member 11, however, preferably not porous. Thus, the material of the first contact layer 24 may (at least mostly) be copper, aluminum, or gold, respectively to the material of the porous metal of the first bonding member(s) 11.

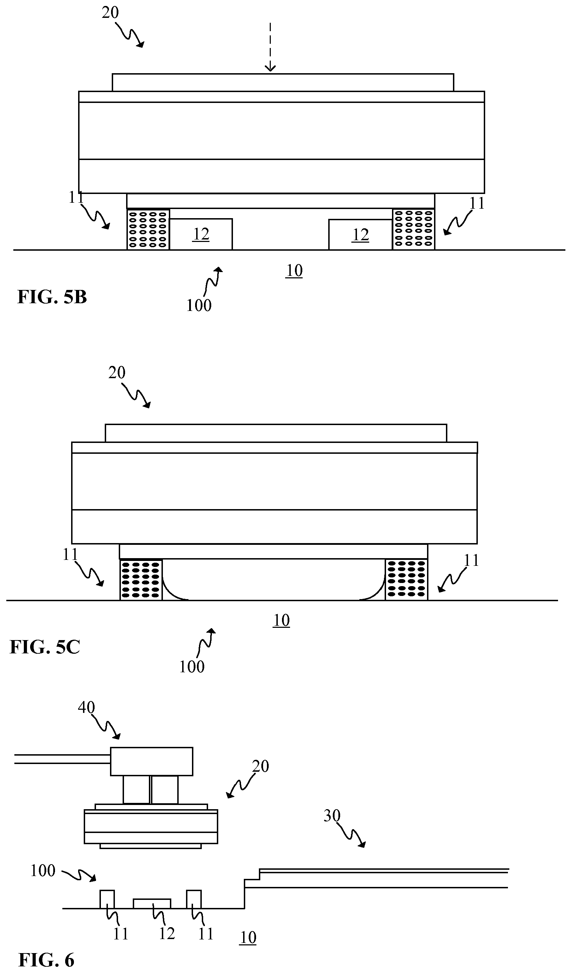

Figures 5A-5C illustrate schematically some stages of aligning and bonding a semiconductor optical device 20 with an optical circuit 30 on a substrate 10 using a bonding structure 100. In this case too, the material of the first bonding member(s) 11 is porous metal. As shown in Fig. 5A, the second bonding members 12 (there could alternatively be only one) are arranged adjacent relative to the first bonding member 11. In Fig. 5A, the semiconductor optical device 20 is being bonded with the first bonding members 11. In Fig. 5B, a force is applied to move the semiconductor optical device 20 so that the length of the first bonding members 11 reduces. This is illustrated in Fig. 5B by the ellipses (corresponding to the small circles in Fig. 5A) within the first bonding member 11 and also by the reduced height of the bonding members 11.

Figure 5C illustrates that the second bonding members 12 are arranged relative to the first bonding member 11 so that upon melting of the second bonding member 12, material of the second bonding members 12 penetrates the porous metal of the corresponding ones of at least one first bonding member 11, respectively, thereby forming an intermetallic compound. This is emphasized in Fig. 5C by the black fill color of the ellipses within the bonding members 11. The penetration of the material of the second bonding member 12 then fixes the semiconductor optical device 20 to its aligned position since the first bonding member 11 becomes at least less, if not completely, non-porous and thereby more rigid. Fig. 5C has small "tails" drawn next to the first bonding member 11 to merely indicate that the material of the second bonding members 12 has penetrated the first bonding member 11. However, in practice, small amount of material may be left out to form such tails.

Figure 6 illustrate schematically a flip-chip bonding device 40 or arm 40 utilizable in aligning an optical axis OAX1 of a semiconductor optical device 20 with that OAX2 of an optical circuit 30 on a substrate 10. The flip-chip bonding device 40 or arm 40 can be used to produce the force for moving the semiconductor optical device 20 and thus for aligning the optical axes OAX1, OAX2. The flip-chip bonding device 40 or arm 40 can be used to move the semiconductor optical device 20 in vertical and/or horizontal directions, or basically all directions. Thus, the force can have any direction.

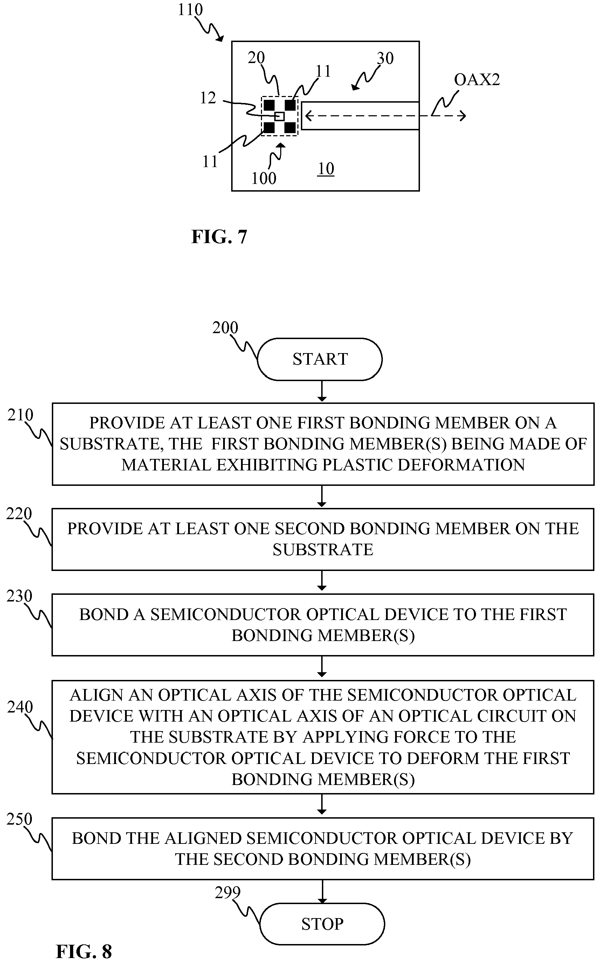

Figure 7 illustrates schematically a photonic integrated circuit 110 as viewed from above. The photonic integrated circuit 110 comprises the optical circuit 30 and the semiconductor optical device 20 on the substrate 10. Furthermore, the semiconductor optical device 20 has been bonded to the substrate 10 by four first bonding members 11 arranged to corner portions of the semiconductor optical device 20. There is one second bonding portion 12 in the middle of the four first bonding members 11 with which the semiconductor optical device 20 has also been bonded to the substrate 10 after the aligning of the optical axes OAX1, OAX2. The plurality of first bonding members 11 may thus be arranged on opposite sides of the at least one second bonding member 12 on the substrate 10. Optical axis OAX1 has been omitted from Fig. 7 for the sake of legibility. The number of first bonding members 11 and/or the second bonding member 12 could easily be different than in Fig. 7.

Figure 8 shows a flow diagram of a method. Item (or method step) 210 refers to an optional general start-up phase of the method. Suitable equipment and components are obtained and systems assembled and configured for operation.

Item 210 refers to providing at least one first bonding member 11 on the substrate 10 for first, or initial, bonding the semiconductor optical device 20 to the substrate 10, wherein the first bonding member 11 is, or members 11 are, made of material exhibiting plastic deformation to allow deforming of the at least one first bonding member 11.

Item 220 refers to providing at least one second bonding member 12 on the substrate 10 for second, or final, bonding the semiconductor optical device 120 to the substrate 10.

In various embodiments, the order of items 210 and 220 may different or even be performed substantially simultaneously.

Item 230 refers to bonding the semiconductor optical device 20 to the at least one first bonding member 11. This may be performed by utilizing an elevator temperature to at least partly melt the surfaces which are to become in contact with each other during the bonding.

Item 240 refers to aligning the optical axis OAX1 of the semiconductor optical device 20 with the optical axis OAX2 of the optical circuit 30 by applying force to the semiconductor optical device 20, such as by a flip-chip bonder head or arm, to deform the at least one first bonding member 11.

Item 250 refers to bonding the aligned semiconductor optical device 20 by the at least one second bonding member 12.

In some embodiments, the method may comprise melting the at least one second bonding member 12 in a reflow soldering process. In the reflow soldering process, the second bonding member(s) 12 may then bond and fix the semiconductor optical device 20 in its aligned position. This may be performed as shown in Figs. 2A-2D or 5A-5C.

Method execution may be stopped at item 299.

## Claims

1. A bonding structure (100) on a substrate (10) for active alignment of an optical axis (OAX1) of a semiconductor optical device (20) with an optical axis (OAX2) of an optical circuit (30) on the substrate (10), wherein the bonding structure (100) comprises:
at least one first bonding member (11) on the substrate (10) for first bonding the semiconductor optical device (20) to the substrate (10), wherein the first bonding member (11) is made of material exhibiting plastic deformation to allow deforming of the at least one first bonding member (11) during the active alignment, wherein the material is porous metal, and
at least one second bonding member (12) on the substrate (10) for second bonding the semiconductor optical device (20) to the substrate (10) upon completion or after the active alignment, wherein the at least one second bonding member (12) is arranged to act as a stopper during or upon completion of the active alignment.

2. The bonding structure (100) of claim **1,** wherein the porous metal is selected from the group consisting of: porous copper, porous aluminum, porous gold.

3. The bonding structure (100) of any one of claims 1-2, wherein the at least one second bonding member (12) is of solder or eutectic bonding material.

4. The bonding structure (100) of any one of claims 1-3, wherein the at least one second bonding member (12) is arranged relative to the first bonding member (11) so that upon melting of the second bonding member (12), material of the second bonding member penetrates the porous metal of the at least one first bonding member (11), thereby forming an intermetallic compound.

5. The bonding structure (100) of claim 4, wherein the at least one second bonding member (12) is arranged adjacent to the first bonding member (11) on the substrate (10).

6. The bonding structure (100) of any one of claims 1-5, wherein an opposite end of the at least one first bonding member (11) relative to the substrate (10) extends beyond an opposite end of the at least one second bonding member (12) relative to the substrate (10).

7. The bonding structure (100) of any one of claims 1-6, comprising a plurality of first bonding members (11) arranged on opposite sides of the at least one second bonding member (12) on the substrate (10).

8. The bonding structure (100) of any one of claims 1-7, wherein the at least one first bonding member **(11)** has or the plurality of first bonding members **(11)** have a longitudinal shape in a direction away from the substrate (10).

9. A photonic integrated circuit (110) comprising:
an optical circuit (30) on a substrate (10), and
a semiconductor optical device (20) aligned with the optical circuit (30) and bonded to the substrate (10) by a bonding structure (100) of any one of claims 1-8.

10. The photonic integrated circuit (110) of claim 9, wherein the semiconductor optical device (20) is one selected from the group consisting of: a semiconductor optical amplifier, a photodiode, a laser diode.

11. A method for active alignment of an optical axis (OAX1) of a semiconductor optical device (20) with an optical axis (OAX2) of an optical circuit (30) on a substrate (10), the method comprising:
providing (210) at least one first bonding member (11) on the substrate (10) for first bonding the semiconductor optical device (20) to the substrate (10), wherein the first bonding member (11) is made of material exhibiting plastic deformation to allow deforming of the at least one first bonding member (11), the material being porous metal,
providing (220) at least one second bonding member (12) on the substrate (10) for second bonding the semiconductor optical device (20) to the substrate (10), wherein the at least one second bonding member (12) is arranged to act as a stopper during or upon completion of the active alignment,
bonding (230) the semiconductor optical device (20) to the at least one first bonding member **(11),**
aligning (240) the optical axis (OAX1) of the semiconductor optical device (20) with the optical axis (OAX2) of the optical circuit (30) by applying force to the semiconductor optical device (20) to deform the at least one first bonding member (11), and
bonding (250) the aligned semiconductor optical device (20) by the at least one second bonding member (12).

12. The method of claim 11, wherein the aligning (240) comprises applying the force by a flip-chip bonder head (40) or arm (40) holding the semiconductor optical device (20) during the active alignment.

13. The method of claim 11 or 12, comprising melting the at least one second bonding member (12) in a reflow soldering process.

## Patentansprüche

1. Verbindungsstruktur (100) auf einem Substrat (10) zur aktiven Ausrichtung einer optischen Achse (OAX1) einer optischen Halbleitervorrichtung (20) mit einer optischen Achse (OAX2) einer optischen Schaltung (30) auf dem Substrat (10), wobei die Verbindungsstruktur (100) Folgendes umfasst:
mindestens ein erstes Verbindungselement (11) auf dem Substrat (10) zum ersten Verbinden der optischen Halbleitervorrichtung (20) mit dem Substrat (10), wobei das erste Verbindungselement (11) aus einem Material hergestellt ist, das eine plastische Verformung aufweist, um eine Verformung des mindestens einen ersten Verbindungselements (11) während der aktiven Ausrichtung zu ermöglichen, wobei das Material poröses Metall ist, und
mindestens ein zweites Verbindungselement (12) auf dem Substrat (10) zum zweiten Verbinden der optischen Halbleitervorrichtung (20) mit dem Substrat (10) nach Abschluss oder nach der aktiven Ausrichtung, wobei das mindestens eine zweite Verbindungselement (12) so angeordnet ist, dass es während oder nach Abschluss der aktiven Ausrichtung als Stopper wirkt.

2. Verbindungsstruktur (100) nach Anspruch 1, wobei das poröse Metall ausgewählt ist aus der Gruppe, bestehend aus: porösem Kupfer, porösem Aluminium, porösem Gold.

3. Verbindungsstruktur (100) nach einem der Ansprüche 1 bis 2, wobei das mindestens eine zweite Verbindungselement (12) aus Lot oder eutektischem Verbindungsmaterial besteht.

4. Verbindungsstruktur (100) nach einem der Ansprüche 1 bis 3, wobei das mindestens eine zweite Verbindungselement (12) relativ zum ersten Verbindungselement (11) angeordnet ist, sodass beim Schmelzen des zweiten Verbindungselements (12) Material des zweiten Verbindungselements in das poröse Metall des mindestens einen ersten Verbindungselements (11) eindringt, wodurch eine intermetallische Verbindung gebildet wird.

5. Verbindungsstruktur (100) nach Anspruch 4, wobei das mindestens eine zweite Verbindungselement (12) neben dem ersten Verbindungselement (11) auf dem Substrat (10) angeordnet ist.

6. Verbindungsstruktur (100) nach einem der Ansprüche 1 bis 5, wobei ein gegenüberliegendes Ende des mindestens einen ersten Verbindungselements (11) in Bezug auf das Substrat (10) über ein gegenüberliegendes Ende des mindestens einen zweiten Verbindungselements (12) in Bezug auf das Substrat (10) hinausragt.

7. Verbindungsstruktur (100) nach einem der Ansprüche 1 bis 6, umfassend eine Vielzahl von ersten Verbindungselementen (11), die auf gegenüberliegenden Seiten des mindestens einen zweiten Verbindungselements (12) auf dem Substrat (10) angeordnet sind.

8. Verbindungsstruktur (100) nach einem der Ansprüche 1 bis 7, wobei das mindestens eine erste Verbindungselement (11) oder die Vielzahl der ersten Verbindungselemente (11) eine längliche Form in einer Richtung weg vom Substrat (10) aufweist.

9. Photonische integrierte Schaltung (110), umfassend: eine optische Schaltung (30) auf einem Substrat (10), und eine optische Halbleitervorrichtung (20), die mit der optischen Schaltung (30) ausgerichtet und mit dem Substrat (10) durch eine Verbindungsstruktur (100) nach einem der Ansprüche 1 bis 8 verbunden ist.

10. Photonische integrierte Schaltung (110) nach Anspruch 9, wobei die optische Halbleitervorrichtung (20) eine ist, die ausgewählt ist aus der Gruppe, bestehend aus: einem optischen Halbleiterverstärker, einer Photodiode, einer Laserdiode.

11. Verfahren zur aktiven Ausrichtung einer optischen Achse (OAX1) einer optischen Halbleitervorrichtung (20) mit einer optischen Achse (OAX2) einer optischen Schaltung (30) auf einem Substrat (10), das Verfahren umfassend:
Bereitstellen (210) mindestens eines ersten Verbindungselements (11) auf dem Substrat (10) zum ersten Verbinden der optischen Halbleitervorrichtung (20) mit dem Substrat (10), wobei das erste Verbindungselement (11) aus einem Material hergestellt ist, das eine plastische Verformung aufweist, um eine Verformung des mindestens einen ersten Verbindungselements (11) zu ermöglichen, wobei das Material poröses Metall ist,
Bereitstellen (220) mindestens eines zweiten Verbindungselements (12) auf dem Substrat (10) zum zweiten Verbinden der optischen Halbleitervorrichtung (20) mit dem Substrat (10), wobei das mindestens eine zweite Verbindungselement (12) so angeordnet ist, dass es während oder nach Abschluss der aktiven Ausrichtung als Stopper wirkt,
Verbinden (230) der optischen Halbleitervorrichtung (20) mit dem mindestens einen ersten Verbindungselement (11), Ausrichten (240) der optischen Achse (OAX1) der optischen Halbleitervorrichtung (20) mit der optischen Achse (OAX2) der optischen Schaltung (30) durch Aufbringen einer Kraft auf die optische Halbleitervorrichtung (20), um das mindestens eine erste Verbindungselement (11) zu verformen, und
Verbinden (250) der ausgerichteten optischen Halbleitervorrichtung (20) durch das mindestens eine zweite Verbindungselement (12).

12. Verfahren nach Anspruch 11, wobei das Ausrichten (240) das Aufbringen der Kraft durch einen Flip-Chip-Bonder-Kopf (40) oder Arm (40) umfasst, der die optische Halbleitervorrichtung (20) während der aktiven Ausrichtung hält.

13. Verfahren nach Anspruch 11 oder 12, umfassend das Schmelzen des mindestens einen zweiten Verbindungselements (12) in einem Aufschmelzlötprozess.

## Revendications

1. Structure de liaison (100) sur un substrat (10) permettant l'alignement actif d'un axe optique (OAX1) d'un dispositif optique à semi-conducteur (20) avec un axe optique (OAX2) d'un circuit optique (30) sur le substrat (10), dans laquelle la structure de liaison (100) comprend:
au moins un premier élément de liaison (11) sur le substrat (10) permettant une première liaison du dispositif optique à semi-conducteur (20) au substrat (10), dans laquelle le premier élément de liaison (11) est constitué d'un matériau présentant une déformation plastique afin de permettre la déformation de l'au moins un premier élément de liaison (11) pendant l'alignement actif, dans laquelle le matériau est un métal poreux, et
au moins un second élément de liaison (12) sur le substrat (10) permettant une seconde liaison du dispositif optique à semi-conducteur (20) au substrat (10) à la fin ou après l'alignement actif, dans laquelle l'au moins un second élément de liaison (12) est agencé pour servir de butée pendant ou à la fin de l'alignement actif.

2. Structure de liaison (100) selon la revendication 1, dans laquelle le métal poreux est choisi parmi le groupe constitué de: cuivre poreux, aluminium poreux, or poreux.

3. Structure de liaison (100) selon l'une quelconque des revendications 1 à 2, dans laquelle l'au moins un second élément de liaison (12) est en matériau de soudure ou de liaison eutectique.

4. Structure de liaison (100) selon l'une quelconque des revendications 1 à 3, dans laquelle l'au moins un second élément de liaison (12) est agencé par rapport au premier élément de liaison (11) de telle sorte que, lors de la fusion du second élément de liaison (12), le matériau du second élément de liaison pénètre dans le métal poreux de l'au moins un premier élément de liaison (11), formant ainsi un composé intermétallique.

5. Structure de liaison (100) selon la revendication 4, dans laquelle l'au moins un second élément de liaison (12) est agencé à côté du premier élément de liaison (11) sur le substrat (10).

6. Structure de liaison (100) selon l'une quelconque des revendications 1 à 5, dans laquelle une extrémité opposée de l'au moins un premier élément de liaison (11) par rapport au substrat (10) s'étend au-delà d'une extrémité opposée de l'au moins un second élément de liaison (12) par rapport au substrat (10).

7. Structure de liaison (100) selon l'une quelconque des revendications 1 à 6, comprenant une pluralité de premiers éléments de liaison (11) agencés sur des côtés opposés de l'au moins un second élément de liaison (12) sur le substrat (10).

8. Structure de liaison (100) selon l'une quelconque des revendications 1 à 7, dans laquelle l'au moins un premier élément de liaison (11) ou la pluralité de premiers éléments de liaison (11) a une forme longitudinale dans une direction s'éloignant du substrat (10).

9. Circuit intégré photonique (110) comprenant :
un circuit optique (30) sur un substrat (10), et
un dispositif optique à semi-conducteur (20) aligné avec le circuit optique (30) et lié au substrat (10) par une structure de liaison (100) selon l'une quelconque des revendications 1 à 8.

10. Circuit intégré photonique (110) selon la revendication 9, dans lequel le dispositif optique à semi-conducteur (20) est choisi parmi le groupe constitué de : un amplificateur optique à semi-conducteur, une photodiode, une diode laser.

11. Procédé permettant l'alignement actif d'un axe optique (OAX1) d'un dispositif optique à semi-conducteur (20) avec un axe optique (OAX2) d'un circuit optique (30) sur un substrat (10), le procédé comprenant:
la fourniture (210) d'au moins un premier élément de liaison (11) sur le substrat (10) pour une première liaison du dispositif optique à semi-conducteur (20) au substrat (10), dans laquelle le premier élément de liaison (11) est constitué d'un matériau présentant une déformation plastique afin de permettre la déformation de l'au moins un premier élément de liaison (11), le matériau étant un métal poreux,
la fourniture (220) d'au moins un second élément de liaison (12) sur le substrat (10) pour une seconde liaison du dispositif optique à semi-conducteur (20) au substrat (10), dans laquelle l'au moins un second élément de liaison (12) est agencé pour servir de butée pendant ou à la fin de l'alignement actif,
la liaison (230) du dispositif optique à semi-conducteur (20) à l'au moins un premier élément de liaison (11),
l'alignement (240) de l'axe optique (OAX1) du dispositif optique à semi-conducteur (20) avec l'axe optique (OAX2) du circuit optique (30) en appliquant une force sur le dispositif optique à semi-conducteur (20) afin de déformer l'au moins un premier élément de liaison (11), et
la liaison (250) du dispositif optique à semi-conducteur aligné (20) par l'au moins un second élément de liaison (12).

12. Procédé selon la revendication 11, dans lequel l'alignement (240) comprend l'application de la force par une tête (40) ou un bras (40) de soudeuse de puce retournée maintenant le dispositif optique à semi-conducteur (20) pendant l'alignement actif.

13. Procédé selon la revendication 11 ou 12, comprenant la fusion de l'au moins un second élément de liaison (12) dans un procédé de soudage par refusion.
